# EUROPEAN PATENT SPECIFICATION

(11) **EP 4 109 531 B1**
(45) Date of publication and mention of the grant of the patent: **27.08.2025**
(21) Application number: 22164177.2
(22) Date of filing: 24.03.2022
(51) Int. Cl.: H10D 84/01, H10D 84/03, H10D 89/60

(54) **ELECTROSTATIC DISCHARGE PROTECTION DIODE FOR BACK-SIDE POWER DELIVERY TECHNOLOGIES AND METHODS OF FABRICATION**
ELEKTROSTATISCHE ENTLADUNGSSCHUTZDIODE FÜR RÜCKSEITIGE STROMVERSORGUNGSTECHNOLOGIEN UND VERFAHREN ZUR FABRIKATION
DIODE DE PROTECTION CONTRE LES DÉCHARGES ÉLECTROSTATIQUES POUR TECHNOLOGIES DE DISTRIBUTION DE PUISSANCE ARRIÈRE ET PROCÉDÉS DE FABRICATION

(30) Priority: 25.06.2021 US 202117358934
(43) Date of publication of application: 28.12.2022
(73) Proprietor: Intel Corporation, Santa Clara, CA 95054 (US)
(72) Inventor: GROVER, Rohit, West Linn, 97068 (US); ORR, Benjamin, Beaverton, 97008 (US); KOLLURU, Kalyan, Portland, 97214 (US); JACK, Nathan, Forest Grove, 97116 (US); THOMSON, Nicholas, Beaverton, OR 97007 (US); KAR, Ayan, Portland, 97229 (US); MA, Rui, Portland, 97229 (US)
(74) Representative: HGF

(56) References cited:
- CN-A- 112 117 270
- US-A1- 2017 125 397
- US-A1- 2018 145 030
- US-A1- 2021 020 624
- US-A1- 2021 028 112

## Description

### BACKGROUND

Semiconductor devices such as logic transistors and transistors coupled with memory devices may be susceptible to damage due to process-induced charging during the manufacturing process, due to electrostatic discharge (ESD) events that occurs during packaging and during normal use. Reliable manufacturing processes that produce such integrated circuits may require some form of electrostatic discharge (ESD) protection to prevent component damage. Electrostatic discharge (ESD) protection diodes can be placed adjacent to logic transistors. However, with device scaling patterning of different structures for different types of devices can introduce process complexities (extra masks, extra electrical routing through different layers) and yield issues. Backside power delivery technologies, which utilize two or more substrates that are bonded together can provide additional circuit features, but present pathways for device degradation. Thus, new ways of integrating ESD diodes with transistors are needed.
US 2018/145030 describes an integrated circuit (IC) chip having power and ground rails incorporated in the front end of line (FEOL). In one aspect, these power and ground rails are at the same level as the active devices and are therefore buried deep in the IC, as seen from the front of the chip. The connection from the buried interconnects to the source and drain areas is established by local interconnects. These local interconnects are not part of the back end of line, but they are for the most part embedded in a pre-metal dielectric layer onto which the BEOL is produced. In a further aspect, a power delivery network (PDN) of the IC is located in its entirety on the backside of the chip. The PDN is connected to the buried interconnects through suitable connections, for example metal-filled through-semiconductor vias or through silicon vias.
CN 112117270 describes a diode device including a first fin region over a first conductive region and an insulator region, and a second fin region over a second conductive and insulator regions, where the second fin region is laterally adjacent to the first fin region, and the insulator region is between the first and second conductive regions. The diode device includes a first conductive via on the first conductive region, where the first conductive via is vertically adjacent to the first fin region, and a second conductive via on the second conductive region, where the second conductive via is vertically adjacent to the second fin region. The diode device may include conductive contacts, first portions on the first fin region, second portions on the second fin region, and gate electrodes between the first and second portions and the conductive contacts.
US 2017/125397 describes a semiconductor device including a substrate, a plurality of first-type fin members, and a plurality of second-type fin members. The substrate includes a first-type region and a second-type region. The first-type region and the first-type fin members are n-type if the second-type region and the second-type fin members are p-type. The first-type region and the first-type fin members are p-type if the second-type region and the second-type fin members are n-type. The first-type region directly contacts the second-type region in a cross-sectional view of the semiconductor device. The first-type region directly contacts each of the first-type fin members in the cross-sectional view of the semiconductor device. The second-type region directly contacts each of the second-type fin members in the cross-sectional view of the semiconductor device.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.
Figure 1A is a cross-sectional illustration of a device structure including an ESD protection P-N diode structure adjacent to a plurality of fin structures over a plurality of regions, in accordance with an embodiment of the present disclosure.
Figure 1B is a cross-sectional illustration of the structure in Figure 1A including a direction of the current path through various interconnects and the ESD protection P-N diode structure.
Figure 1C is a cross-sectional illustration of a plurality of transistors formed above a plurality of fin structures, in accordance with an embodiment of the present disclosure.
Figure 1D is an enhanced cross-sectional illustration through fins, in the first region, on a plane in front of the plane of depicted in Figure 1A.
Figure 2 is a cross-sectional illustration of a device structure including an ESD protection diode structure adjacent to a plurality of fin structures over a plurality of regions, in accordance with an embodiment of the present disclosure.
Figure 3 is a cross-sectional illustration of a device structure including an ESD protection diode structure below a plurality of fin structures, in accordance with an embodiment of the present disclosure.
Figure 4 is an illustration of a flow chart to fabricate fin structures and an ESD protection diode below the plurality of fin structures, in accordance with an embodiment of the present disclosure.
Figure 5A is a cross-sectional illustration of a plurality of fins formed above a substrate.
Figure 5B is a cross-sectional illustration of the structure in Figure 5A following the formation of a first well region in a first portion of the substrate and doping of a first plurality of fins above the first well region, in accordance with an embodiment of the present disclosure.
Figure 5C is a cross-sectional illustration of the structure in Figure 5B following the formation of a second well region in a second portion of the substrate and doping of a second plurality of fins above the second well region, in accordance with an embodiment of the present disclosure.
Figure 5D is a cross-sectional illustration of the structures in Figure 5C following the process to deposit a dielectric on the plurality of fins, and then removing a portion of the substrate.
Figure 5E is a cross-sectional illustration of the structures in Figure 5D following the process to etch and remove portions of the substrate away from the first and the second wells and expose an upper surface of each of the plurality of fins.
Figure 5F is a cross-sectional illustration of the structures in Figure 5E following the process to deposit a second dielectric layer on the upper surface of each of the plurality of fins and form a first plurality of interconnects in the second dielectric laterally distant from the substrate, in accordance with an embodiment of the present disclosure.
Figure 5G is a cross-sectional illustration of the structures in Figure 5 following the process to deposit a third dielectric layer on the upper surface of each of the first plurality of interconnects and form a second plurality of interconnects in the third dielectric, in accordance with an embodiment of the present disclosure.
Figure 5H is a cross-sectional illustration of the structures in Figure 5G following the process to form a third plurality of interconnects in the first dielectric, where at least one interconnect in the third plurality of interconnects is formed on each of first plurality of interconnects, in accordance with an embodiment of the present disclosure.
Figure 6A is a cross-sectional illustration of the structure in Figure 5B following the process to target doping a portion of the substrate adjacent to a first well.
Figure 6B is a cross-sectional illustration of the structure in Figure 6A following the process to implant a dopant of an opposite conductivity type to the dopant utilized to form the first well.
Figure 7 is a cross-sectional illustration of a process to form a first well in a substrate of a workpiece that includes a plurality of fins fabricated above the substrate.
Figure 8 illustrates a computing device in accordance with embodiments of the present disclosure.
Figure 9 illustrates an integrated circuit (IC) structure.

### DETAILED DESCRIPTION

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.

Various configurations of electrostatic discharge diode structures and transistor devices and are described. In the following description, numerous specific details are set forth, such as structural schemes and detailed fabrication methods in order to provide a thorough understanding of embodiments of the present disclosure. It will be apparent to one skilled in the art that embodiments of the present disclosure may be practiced without these specific details. In other instances, well-known features, such as transistor and diode operations, are described in lesser detail in order to not unnecessarily obscure embodiments of the present disclosure. Furthermore, it is to be understood that the various embodiments shown in the Figures are illustrative representations and are not necessarily drawn to scale.

In some instances, in the following description, well-known methods and devices are shown in block diagram form, rather than in detail, to avoid obscuring the present disclosure. Reference throughout this specification to "an embodiment" or "one embodiment" or "some embodiments" means that a particular feature, structure, function, or characteristic described in connection with the embodiment is included in at least one embodiment of the disclosure. Thus, the appearances of the phrase "in an embodiment" or "in one embodiment" or "some embodiments" in various places throughout this specification are not necessarily referring to the same embodiment of the disclosure. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical, electrical or in magnetic contact with each other, and/or that the two or more elements co-operate or interact with each other (e.g., as in a cause an effect relationship).

The terms "over," "under," "between," and "on" as used herein refer to a relative position of one component or material with respect to other components or materials where such physical relationships are noteworthy. For example, in the context of materials, one material or material disposed over or under another may be directly in contact or may have one or more intervening materials. Moreover, one material disposed between two materials may be directly in contact with the two layers or may have one or more intervening layers. In contrast, a first material "on" a second material is in direct contact with that second material/material. Similar distinctions are to be made in the context of component assemblies. As used throughout this description, and in the claims, a list of items joined by the term "at least one of" or "one or more of" can mean any combination of the listed terms.

The term "adjacent" here generally refers to a position of a thing being next to (e.g., immediately next to or close to with one or more things between them) or adjoining another thing (e.g., abutting it).

The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

As used throughout this description, and in the claims, a list of items joined by the term "at least one of" or "one or more of" can mean any combination of the listed terms.

Unless otherwise specified in the explicit context of their use, the terms "substantially equal," "about equal" and "approximately equal" mean that there is no more than incidental variation between two things so described. In the art, such variation is typically no more than +/-10% of a predetermined target value.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

Electrostatic discharge (ESD) is one of the most prevalent threats to electronic components. In an ESD event, a large amount of charge is transferred during the fabrication process to a component of a microchip (e.g., transistor, capacitor etc.) or during use of an already fabricated SoC device. The ESD event can lead to large amounts of current to pass through the components of a microchip within a very short period of time. Large amounts of uncontrolled current can cause device degradation and, in some cases, render the device dysfunctional. Thus, designing and integrating structures to protect integrated circuits against ESD events is an important component of the semiconductor device fabrication process. The problem of ESD becomes even greater when the substrate utilized to build the electronic components cannot discharge the extra charge adequately. Logic transistor technologies that utilize fin-FET and nanowire architecture have channel geometries with cross sectional area (laterally through a channel for example) that cannot adequately support high discharge currents flow (during an ESD event). Hence, it is desirable to implement ESD protection devices, such as diodes, near or directly adjacent to logic transistors within a portion of the substrate.

In some examples where two or more substrates are bonded together, ESD protection devices can be implemented in one or more of the substrates. However, in some fin-FET and nanowire architecture implementations, capacitance between bulk substrate directly below fin structures or nanowires and adjacent well of a diode can detrimentally affect transistor characteristics.

The inventors have devised a solution to address proximity of ESD protection devices to logic transistors as well as capacitance issues.

The present invention concerns a device as defined in claim 1. Preferred embodiments are defined in the dependent claims.

In one embodiment, the solution involves removing portions of a substrate directly below fins of active transistors but leaving a portion of the substrate in an adjacent region for diode implementation. The fins of respective transistors are above a dielectric that is adjacent to the substrate. In one such embodiment, a first top portion of the substrate is doped with a dopant of a first conductivity type to form a first well and an adjacent second top portion of the substrate is doped with a dopant of a second conductivity type to form a second well of a diode. The boundary between the first and the second well is a P-N junction of the diode. A plurality of fins are also present above the first and the second well. One or more of the plurality of fins on each of the first well and the second well may be heavily doped to be a respective terminal of the diode. To facilitate a large-area ESD protection diode, the one or more of the plurality of doped fins on each of the first well and the second well are coupled with a respective first and a second interconnect below the level of the substrate. The respective first and a second interconnect may have lateral extensions that extend laterally below fins of active transistors as well as under the diode. In bulk substrates, integration schemes that can co-fabricate transistors alongside an ESD protection device by utilizing fin structures as source and drain for respective transistors and doped fin structures as terminals of diodes can provide significant process advantages and offer cost benefits. Cost savings can stem from a lack of a need to implement separate masks for forming terminals of the diode by utilizing fin patterning to simultaneously form fins and terminals for transistors and one or more diodes, respectively, for example.

Devices on floating substrates such as silicon on insulator (SOI) substrates are especially prone to destruction caused by ESD events. ESD protection devices implemented on an SOI substrate do not have the same depth as their bulk counterpart. The junctions are shallower reducing the volume for heat dissipation. The insulator below devices formed on the thin silicon layer, for example, are not as effective for heat dissipation to the substrate below the insulator. However, to overcome this limitation transistors including fins (in a fin-FET implementation) are located on a level above the insulator or buried oxide, and one or more diodes may be implemented in the substrate portion below the insulator by preferentially doping the substrate below the insulator layer.

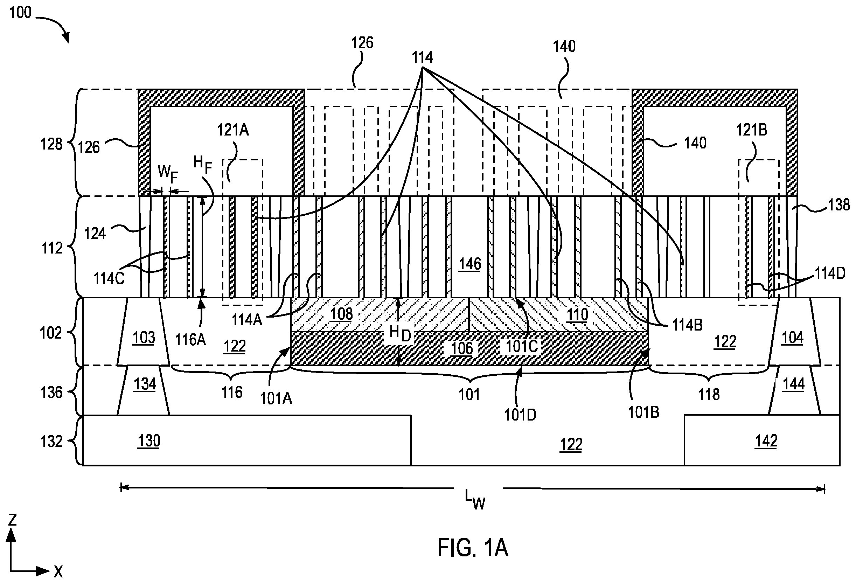

Figure 1A is a cross-sectional illustration of a semiconductor structure 100 including a diode 101. A level 102 of the semiconductor structure 100 includes an interconnect 103 and an interconnect 104 and a substrate 106 between the interconnects 103 and 104. The substrate 106 may include one or more wells that form a P-N junction of the diode 101. In the illustrative embodiment, diode 101 includes a well 108 on a first portion of the substrate 106, and a well 110 on a second portion of the substrate 106, directly adjacent to the first portion. The wells 108 and 110 each include a respective dopant of a first conductivity type and of a second conductivity type. In an embodiment, the well 108 has a first conductivity associated with a p-type dopant species and the well 110 has a second conductivity associated with an n-type dopant species. In an embodiment p-type dopants includes impurity species such as, but not limited to, boron, aluminum, gallium, indium, titanium, and nihonium. In an embodiment n-type dopants include impurity species such as, but not limited to, nitrogen, phosphorus, arsenic, antimony, bismuth, and moscovium. In a different embodiment, the well 108 has a first conductivity type associated with an n-type dopant species and the well 110 has a second conductivity type associated with a p-type dopant species. In some embodiments, the substrate 106 and the wells 108 or 110 have a total combined thickness, H_{D}. H_{D} can range between 200 nm and 500 nm. The total thickness is substantially less than a total thickness of a silicon substrate, but adequate for an ESD diode. While, H_{D}, is essentially a thickness of the level 102, interconnects 103 and 104 have a height that is independent of H_{D}. Though in exemplary embodiments, interconnects 103 and 104 have a height that is at least H_{D} but can be greater than H_{D}. An approximately equal vertical thickness of the interconnects 103 and 104 and the combined thickness of substrate 106 and wells 108 or 110 is resultant of a processing operation utilized. In embodiments, interconnects 103 is a metal line extending into or out of the plane of Figure 1A.

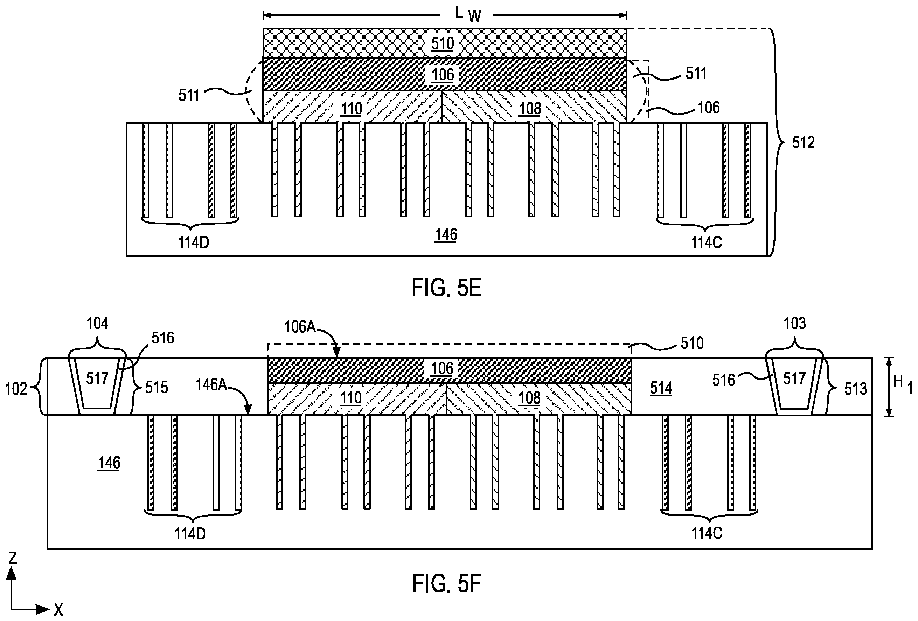

In the illustrative embodiment, sidewalls 101A and 101B of diode 101 are substantially vertical. In other embodiments, the sidewalls 101A and 101B may taper from an uppermost surface 101C to a lower most surface 101D. Profiles of sidewalls 101A and 101B are a result of a processing operation utilized to fabricate diode 101 (described in association with Figure 5E). While wells 108 and 110 are illustrated as having a substantially flat lower most surface, other shapes such as curved lower most surfaces are also possible and depends on distribution of n and p dopants.

The semiconductor structure 100 further includes a level 112 above level 102, where the level 112 includes multiple fins 114 (herein fins 114) over different regions. A total number of fins 114 in the semiconductor structure 100 depends on a lateral width, L_{W} of the semiconductor structure 100. Each of the fins 114 may include a semiconductor material. In some embodiments the semiconductor material includes predominantly silicon, silicon germanium or germanium and may further include different types of dopants depending on the region and on a desired transistor-MOS type that is associated with a particular fin in the fins 114. While each fin 114 includes predominantly a same semiconductor material (other than differences in dopant species), some fins 114 are utilized as source and drain structures for transistors while other fins 114 are utilized as terminals of wells 108 and 110 and include high levels of dopant species advantageous for current conduction to and from wells 108 and 110. The implementation of some of the fins 114, e.g., fins 114A and 114B, as terminals of diode 101 is an advantage of the design of semiconductor structure 100 which includes diode 101.

In the illustrative embodiment, the fins 114A are on well 108 and fins 114B are on well 110. The fins 114A and 114B include a same semiconductor material but dopants of opposite conductivity type. In an exemplary embodiment, fins 114A includes a dopant of the conductivity type of well 108 and the fins 114B includes a dopant of the conductivity type of well 110. In some embodiments, fins 114 and 114B have a dopant gradient that increases in concentration toward the wells 108 and 110, respectively. In other embodiments, the dopant gradient is substantially zero and the fins 114 and 114B are uniformly doped. Depending on routing interconnects, each of the fins 114A may singly or collectively represent a first terminal and each of the fins 114A may singly or collectively represent a second terminal of diode 101.

The semiconductor structure 100 further includes one or more fins over a region 116 between the substrate 106 and interconnect 103 and one or more fins over a region 118 between the substrate 106 and interconnect 104. In the illustrative embodiment, a plurality of fins 114C (herein fins 114C) are shown on the region 116 and a plurality of fins 114D (herein fins 114D) are shown on the region 118. Fins 114C may be associated with a single transistor (within dashed box 121A) or a plurality of transistors above region 116 and fins 114D may be associated with a single transistor (within dashed box 121A) or a plurality of transistors above region 118. Structurally fins 114A, 114B, 114C and 114D may each have a same or substantially the same lateral width W_{F}, and a same or substantially the same height H_{F} relative to an uppermost surface 116A of region 116. As shown, fins 114C and 114D are insulated from the substrate 106 and well 108 by a dielectric 122 within region 116. Electrical insulation from the substrate 106 and well 108 can advantageously reduce junction capacitance between source, drain or channel of one or more of the plurality of transistors within box 121A and the substrate 106, and between source, drain or channel of one or more of the plurality of transistors within box 121B and substrate 106. The number of fins and transistors above regions 116 or 118 depends on a lateral spacing between substrate 106 and respective interconnect 103 or 104. In some embodiments, fins 114A, 114B, 114C and 114D may include pairs of fins, where a first pair is separated from an adjacent pair by a substantially same lateral spacing.

To complete routing between the wells 108 and 110 and various grounding plates, semiconductor structure 100 further includes various interconnects and routing lines across multiple levels. In the illustrative embodiment, interconnect 124 is on and coupled with the interconnect 103 adjacent to fins 114C. The interconnect 124 may be a via or a metal line. The interconnect 124 is electrically coupled with one or more fins 114A through an interconnect 126 (herein routing line 126). The routing line 126 may be within level 112 or as illustrated on a level 128 above level 112. The routing line 126 may electrically couple with well 108 through one or more fins 114A. In the illustrative embodiment, a single fin 114A is coupled to routing line 126. Routing line 126 may be extended on uppermost surfaces of all fins 114A (as indicated by dashed extension of routing line 126) to enable a larger current flux to and from well 108. The interconnect 124 may be electrically coupled to a plate 130 on a level 132 below the substrate 106, through a series of interconnect structures. In the illustrative embodiment, an intermediate interconnect 134 is further implemented on a level 136 between levels 132 and 102 to electrically couple the well 108 with the plate 130.

In the illustrative embodiment, interconnect 138 is on and coupled with the interconnect 104 adjacent to fins 114D in region 118. The interconnect 138 is electrically coupled with one or more fins 114B through an interconnect 140 (herein routing line 140). The routing line 140 may be on level 112 or as illustrated on level 128 above level 112. The routing line 140 may electrically couple with well 110 through one or more fins 114B. In the illustrative embodiment, a single fin 114B is coupled to routing line 140. Routing line 140 may be extended on uppermost surfaces of all fins 114B (as indicated by dashed extension of routing line 140) to enable a larger current flux to and from well 110. The interconnect 138 may be electrically coupled to a plate 142 on the level 132, through a series of interconnect structures. In the illustrative embodiment, an intermediate interconnect 144 is further implemented on level 136 between levels 132 and 102 to electrically couple the well 110 with the plate 142.

Interconnects 124 and 138 may include a material that is compatible with a front-end-of-the-line (FEOL) processing. In some embodiments, interconnects 124 and 138 includes a liner layer implemented as a diffusion blocker and a fill metal that include a high conductivity material other than copper. The liner layer may include a material such as, but not limited to, ruthenium, titanium nitride, tantalum nitride or tantalum and a fill metal may include tungsten, ruthenium or molybdenum. Interconnects 103, 104, 134 and 144 and routing lines 126 and 140 may include copper as a fill metal in addition to the materials discussed above and a liner layer may include a material such as, but not limited to, ruthenium, titanium nitride, tantalum nitride or tantalum. Routing lines 126 and 140 may include a copper-based interconnect material or a non-copper-based material such as a material of the interconnect 124. In embodiments where routing lines 126 and 140 include copper, the copper may be surrounded by a diffusion barrier material to prevent copper diffusion into a transistor region, such as above regions 116 and 118.

In embodiments, dielectric 122 spans levels 132, 136 and 102 as shown. In some embodiments, dielectric 122 includes silicon and one or more of nitrogen, oxygen and carbon, for example, silicon nitride, silicon dioxide, carbon doped silicon nitride, silicon oxynitride or silicon carbide. The semiconductor structure 100 further includes a dielectric 146 adjacent to the fins 114. The dielectric 146 is on dielectric 122 and on portions of interconnects 103, 104, and on portions of wells 108 and 110. In embodiments, dielectric 146 includes a material that is the same or substantially the same as the material of the dielectric 122.

The combination of plate 130, interconnects 124, 103 and 134, routing line 126, one or more fins 114A, wells 108 and 110, one or more fins 114B, routing line 126, interconnects 138, 104 and 144, and plate 142 constitutes a diode 101 circuit.

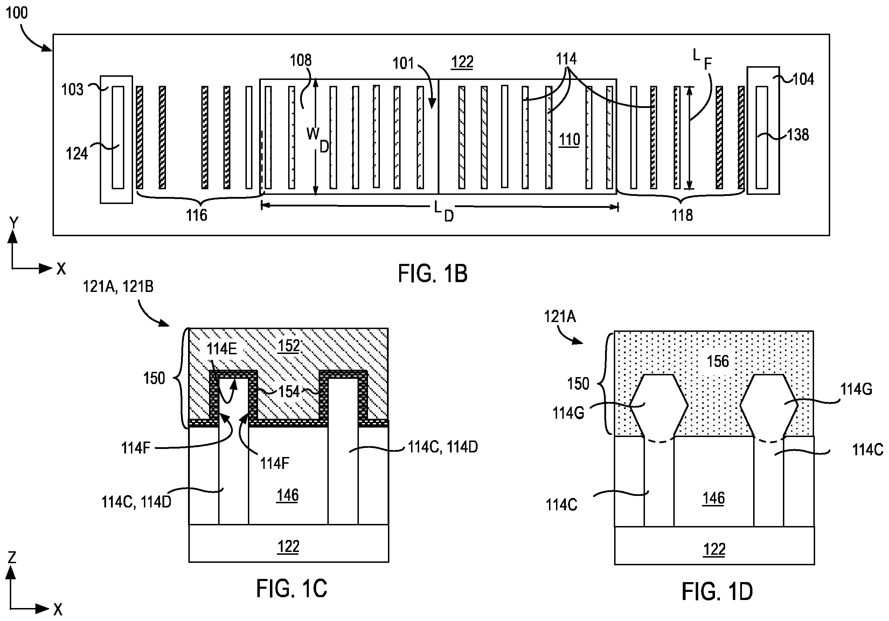

Figure 1B is a plan view illustration of the semiconductor structure 100 in Figure 1A, through a line A-A'. Various structures are superimposed for illustrative purposes only. The diode has a length L_{D} and a width, W_{D} that are determined by a total current requirement of the ESD protection sought. The diode 101 width, W_{D} may extend beyond an entire length L_{F}, of fins 114 or be less than L_{F}. In the illustrative embodiment, diode 101 W_{D} is greater than L_{F}. In embodiments, L_{D} is between 50 nm - 2 microns and W_{D} is between 100 nm and 2 microns.

Figure 1C is an enhanced cross-sectional illustration of the box region 121A and 121B depicting a transistor 150, in accordance with an embodiment of the present disclosure. In the illustrative embodiment, a single transistor 150 is shown where the transistor is an example of a fin-FET architectures. As shown transistor 150 straddles a pair of fins 114C or 114D. The transistor includes a gate electrode 152 and a gate dielectric layer 154 between uppermost surfaces 114E and sidewalls 114F of fins 114C or 114D. In the illustrative embodiment, the dielectric layer 146 is recessed below uppermost surfaces 114E to facilitate a fin-FET architecture. The fins 114C or 114D extend in and out of the plane of the Figure. Source and drain regions of the transistor 150 are on portions of the fins 114C or 114D through planes that are in and out of the plane of the Figure. In other embodiments, transistor 150 may straddle a single fin 114C or 114D. In an embodiment, the gate dielectric layer 154 includes a high-K gate dielectric material. The gate dielectric layer 154 may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, or zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate. In some embodiments, an annealing process may be carried out on the gate dielectric layer 154 to improve its quality when a high-k material is used.

The gate electrode 152 of the transistor 150 is formed on the gate dielectric layer 154 and may consist of at least one P-type work function metal or N-type work function metal, depending on whether the transistor is to be a PMOS or an NMOS transistor. In some implementations, the gate electrode 152 may include a stack of two or more metal layers, where one or more metal layers are work function metal layers and at least one metal layer is a conductive fill layer.

For a PMOS transistor, metals that may be used for the gate electrode 152 include, but are not limited to, ruthenium, palladium, platinum, cobalt or nickel. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide.

Figure 1D is an enhanced cross-sectional illustration through fins 114C on a plane in front of the plane of depicted in Figure 1A. In the illustrative embodiment, portion of the fins 114C are replaced by a doped source or drain epitaxial structure 114G. The dopants in the doped source epitaxial structure may be different from a N or P type dopant in the wells 108 or 110. In an embodiment, the source or drain epitaxial structure 114G includes Si and Ge, and may be doped with boron, aluminum, gallium, indium, titanium, nihonium, nitrogen, phosphorus, arsenic, antimony, bismuth, or moscovium depending on whether an N-type or a P-type dopant species is required. In the illustrative embodiment, the doped source or drain epitaxial structure 114G is surrounded by a dielectric 156 that is above dielectric 146. Dielectric 156 may include a material that is the same or substantially the same as the material of the dielectric 146.

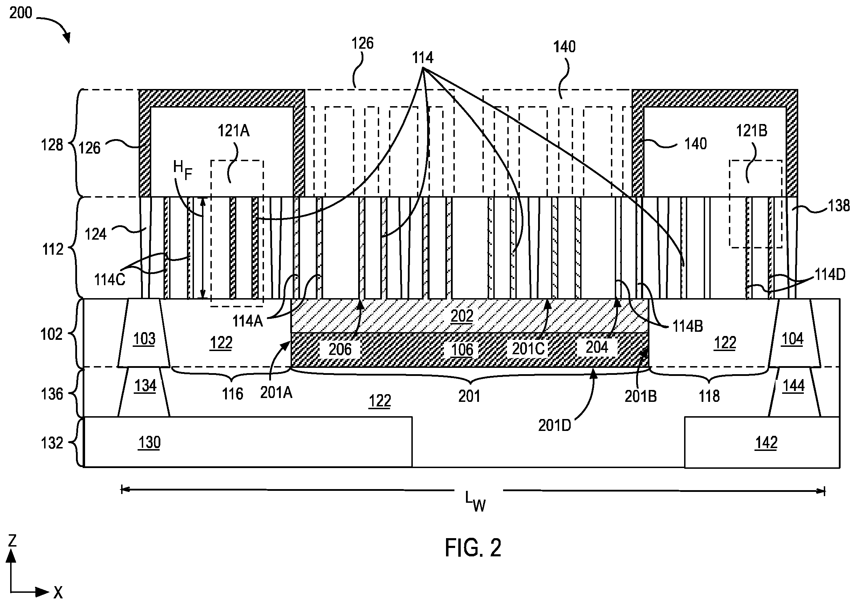

In some embodiments, the diode 101 includes a single well such as well 108 or well 110. Figure 2 is a cross-sectional illustration of a semiconductor structure 200 that includes a diode 201 having a single well 202 above substrate 106. In embodiments well 202 includes one or more features of well 108 or 110 (described in association with Figure 1A). Well 202 includes a semiconductor material that is the same or substantially the same as the material of the substrate 106. The well 202 includes a dopant of a first conductivity type or of a second conductivity type. In the illustrative embodiment, the P-N junction is formed at an interface between well 202 and one of the sets of fins 114A or 114B depending on the conductivity of the dopant species in the fins 114A or 114B relative to the conductivity of the dopant species in the well 202.

In an embodiment, the well 202 and fins 114A both include a dopant of a first conductivity type, and the fins 114B include a dopant of a second conductivity type, that is opposite the first conductivity type. In some such embodiment, a P-N junction is formed at an interface 204 between the well 202 and fins 114B. In other embodiments, the well 202 and fins 114B both include a dopant of a first conductivity type, and the fins 114A include a dopant of a second conductivity type, that is opposite the first conductivity type. In some such embodiment, a P-N junction is formed at an interface 206 between the well 202 and fins 114A. In an embodiment, the first conductivity type is an n-type dopant, and the second conductivity type is a p-type dopant or vice versa. Having a single well 202 compared to laterally adjacent wells 108 and 110 (illustrated in Figure 1A), does not diminish the performance of diode 201.

In the illustrative embodiment, sidewalls 201A and 201B of diode 201 are substantially vertical. In other embodiments, the sidewalls. In other embodiments, the sidewalls 201A and 201B may taper from an uppermost surface 201C to a lower most surface 201D. Profiles of sidewalls 201A and 201B are a result of a processing operation utilized to fabricate diode 201. While well 202 is illustrated as having a substantially flat lower most surface, other shapes such as curved lower most surfaces are also possible and depends on distribution of n or p-type dopants.

In some embodiments, the substrate 106 and the well 202 have a total combined thickness, H_{D}. H_{D} can range between 200 nm and 500 nm. Other parameters such as plan view area of diode 201 may be the same or substantially the same as diode 201. However, because of the absence of a second well, the diode 201 may have a smaller effective plan view surface area of the well 202, where the surface is a horizontal surface in an x-y plane. Other features of semiconductor structure 200 are substantially the same as semiconductor structure 100.

In some semiconductor structures, diodes are implemented on a silicon on insulator substrate.

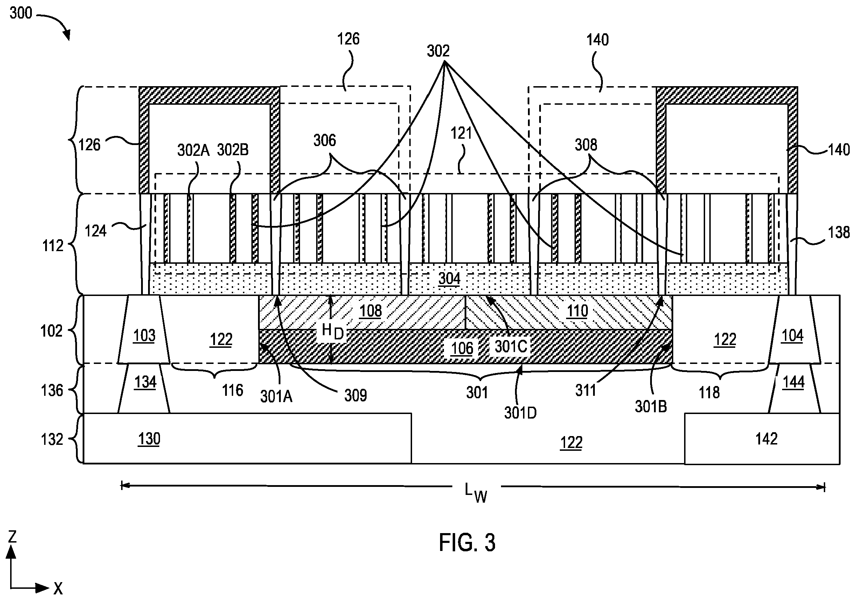

Figure 3 is a cross-sectional illustration of a semiconductor structure 300 implemented on a silicon on insulator type of substrate. Semiconductor structure 300 includes one or more features of the semiconductor structure 100. As shown, level 102 of the semiconductor structure 300 includes an interconnect 103 and an interconnect 104 and a substrate 106 between the interconnects 103 and 104. The substrate 106 may include one or more wells that form a P-N junction of the diode 301. In the illustrative embodiment, diode 301 includes well 108 on a first portion of the substrate 106, and well 110 on a second portion of the substrate 106. The wells 108 and 110 each include a respective dopant of a first conductivity type and of a second conductivity type. In an embodiment, the well 108 has a first conductivity associated with a p-type dopant species and the well 110 has a second conductivity associated with an n-type dopant species. In a different embodiment, the well 108 has a first conductivity type associated with an n-type dopant species and the well 110 has a second conductivity type associated with a p-type dopant species. In some embodiments, the substrate 106 and the wells 108 or 110 have a total combined thickness, H_{D}. H_{D} can range between 200 nm and 500 nm. While, H_{D}, is essentially a thickness of the level 102, interconnects 103 and 104 have a height that is independent of H_{D}. Though in exemplary embodiments, interconnects 103 and 104 have a height that is at least H_{D} and resultant of a processing operation utilized.

In the illustrative embodiment, sidewalls 301A and 301B of diode 301 are substantially vertical. In other embodiments, the sidewalls 301A and 301B may taper from an uppermost surface 301C to a lower most surface 301D. Profiles of sidewalls 301A and 301B are a result of a processing operation utilized to fabricate diode 301 and will be discussed in association with Figure 5E. While wells 108 and 110 are illustrated as having a substantially flat lower most surface, other shapes such as curved lower most surfaces are also possible and depend on distribution of n and p dopants. As shown, the semiconductor structure 300 further includes regions 116 and 118, where region 116 is between the substrate 106 and interconnect 103, and region 118 is between the substrate 106 and interconnect 104.

The semiconductor structure 300 further includes a level 112 above level 102, where the level 112 includes multiple fins 302 (herein fins 302) over different regions such as wells and dielectrics, in contrast to being in contact with the wells 108 and 110 as in semiconductor structure 100 (Figure 1A). The level 112 includes an insulator layer 304 between the level 102 and fins 302. The fins 302 are over but not in contact with the well 108 or 110.

Each of the fins 302 may include a semiconductor material. In some embodiments the semiconductor material includes predominantly silicon, silicon germanium or germanium and depending on the region, further includes different types of dopants. While each fin 302 includes predominantly a same semiconductor material utilized in source and drain structures for transistors, different portions of the fin 302 (in a direction in and out of the plane of the Figure) may be doped differently for different MOS transistor characteristics. For example, Fin 302A may be associated with an NMOS transistor and Fin 302B may be associated with a PMOS transistor. Other features of fin 302, such as width and spacing between successive fins 302, may be substantially identical to fins 114 (Figure 1A and 2).

Because fins 302 are over regions 116 and 118 and over wells 108 and 110, transistors may be associated with each fin 302. In other embodiments, there can be transistors associated with some of the fins 302 and not others. The transistors associated with fins 302 may be all NMOS or all PMOS, or a combination thereof. In one or more embodiments, the transistors in boxed region 121 may be substantially the same as transistors depicted in Figure 1C or discrete transistors above one or more of the fins 302.

The semiconductor structure 300 further includes a level 112 above level 102, where the level 112 includes a plurality of interconnects (herein interconnects) over different regions. As shown, interconnect 124 is on the interconnect 103 and interconnect 138 is on interconnect 104. Unlike diode 101 in Figure 1A, diode 301 utilizes metallic terminals as electrodes in various implementations. For example, interconnects 306 are on well 108 and interconnects 308 are on well 110. In the illustrative embodiment, interfaces 309 and 311 between interconnect 306 and well 108, and between interconnect 308 and well 110, respectively are Schottky barriers.

To complete routing between the wells 108 and 110 and respective grounding plates 130 and 142, semiconductor structure 300 further includes various interconnects and routing lines across multiple levels as discussed previously. The interconnect 124 may be electrically coupled with one or more interconnects on the well 108 through a routing line 126. The routing line 126 may be on level 112 or as illustrated, on a level 128 above level 112. The routing line 126 may be electrically coupled with well 108 through one or more interconnects. In the illustrative embodiment, a single interconnect 306 is coupled to routing line 126. Routing line 126 may be extended on uppermost surfaces of all interconnects 306 (as indicated by dashed extension of routing line 126) to enable a larger current flux to and from well 108. The interconnect 124 may be electrically coupled to a plate 130 on a level 132 below the substrate 106, through a series of interconnect structures as discussed above.

The interconnect 138 may be electrically coupled with one or more interconnects on the well 110 through a routing line 140. The routing line 140 may be on level 112 or as illustrated, on a level 128 above level 112. The routing line 140 may be electrically coupled with well 110 through one or more interconnects. In the illustrative embodiment, a single interconnect 308 is coupled to routing line 140. Routing line 140 may be extended on uppermost surfaces of all interconnects 308 (as indicated by dashed extension of routing line 140) to enable a larger current flux to and from well 110. The interconnect 138 may be electrically coupled to a plate 142 on a level 132 below the substrate 106, through a series of interconnect structures as discussed above. The combination of plate 130, interconnects 124, 103, 134, routing line 126, one or more interconnects 306, wells 108 and 110, one or more interconnects 308, routing line 140, interconnects 138, 104 and 144, and plate 142 constitutes a diode 301 circuit.

The diode 101 facilitates ESD protection to transistors formed above the diode 101.

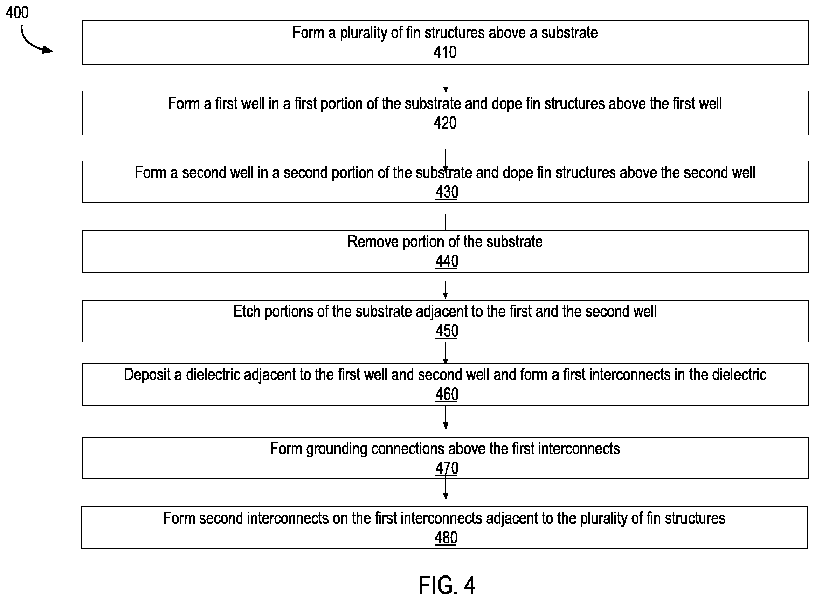

Figure 4 is a method 400 to fabricate an ESD diode and fin structures above the diode for transistors, in accordance with an embodiment of the present disclosure. The method 400 begins at operation 410 with the formation of a plurality of fin structures above a substrate. The method 400 continues at operation 420 with the formation of a first well region in a first portion of the substrate and doping fins above the first well region. The method 400 continues at operation 430 with the formation of a second well region in a second portion of the substrate and doping fins above the second well region. The method 400 continues at operation 440 with the process to deposit a dielectric on the plurality of fins, and then removing a portion of the substrate. The method 400 continues at operation 450 with the process to etch and remove portions of the substrate adjacent to from the first and the second well regions and expose a lower surface of each of the plurality of fins. The method 400 continues at operation 460 with a process to deposit a second dielectric layer on the upper surface of each of the plurality of fins and form a first plurality of interconnect vias in the second dielectric laterally spaced from first and second well, in accordance with an embodiment of the present disclosure. The method 400 continues at operation 470 with a process to form grounding connections above the first interconnects. The method 400 concludes at operation 480 with a process to deposit a third dielectric layer adjacent to the plurality of fins and form a second plurality of interconnect vias in the third dielectric, where at least one interconnect is formed on each of first plurality of interconnects.

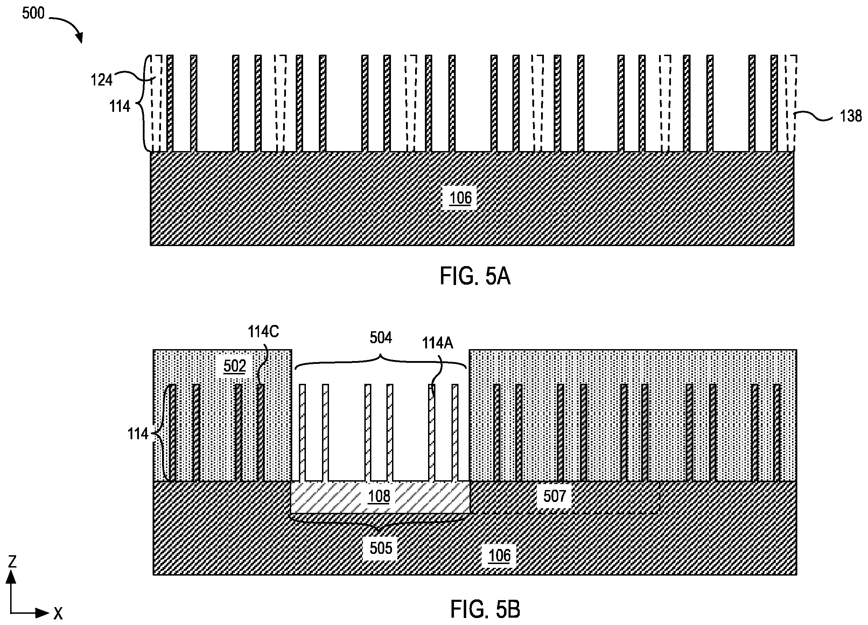

Figure 5A is a cross-sectional illustration of a wafer 500 including a plurality of fins 114 formed above a substrate 106. A mask is formed over a substrate 106. In an embodiment, the mask may be formed by a lithographic process on the substrate 106. In other embodiments, the mask is a hardmask that is not removed by a plasma ash process, for example, a mask fashioned from silicon and one or more of oxygen, nitrogen, or carbon. A plasma etch may be utilized to form the fins 114. The fins can be targeted to a depth that is required for a particular transistor device. The spacing between fins may be designed for placement of interconnects such as interconnect 124 or 138 (indicated in dashed boxes).

In an embodiment, the substrate includes single crystal silicon and the fins can be doped to provide highly doped terminals over well regions and fin-FET transistors over device regions. In other embodiments, the substrate 106 and the fins 114 can include two different materials. For example, substrate 106 can include silicon and the fins 114 can include silicon germanium. In, yet another embodiment, the fins can be formed of a multilayer stack of SiGe/Si bilayer to enable formation of nanowires. The nanowires can be formed in the device regions and the stack of SiGe/Si bilayer can be left as a patterned fin structure that can be doped to form terminals over well regions, in some embodiments.

Figure 5B is a cross-sectional illustration of the structure in Figure 5A following the formation of a well 108 in a region 505 of the substrate 106 and doping of a plurality of fins 114A above the well 108, in accordance with an embodiment of the present disclosure. A first of a dual mask and implant process is described herein.

In an embodiment, a mask 502 is formed over a substrate 106. The mask 502 may be formed by a lithographic process on the fins 114 and on the substrate 106. The mask has a well opening 504 to expose fins 114 and portion of the substrate 106. In an embodiment, the portion of the substrate 106 exposed by well opening 504 is subjected to dopant implant. In an embodiment, the dopants include n-type impurities or p-type impurities. In an embodiment p-type dopants include impurity species such as but not limited to boron, aluminum, gallium, indium, titanium, and nihonium. In an embodiment n-type dopants include impurity species such as but not limited to nitrogen, phosphorus, arsenic, antimony, bismuth, and moscovium. In an embodiment, the n or p-type dopants are implanted into a substrate 106 using an ion implanter. In an embodiment, the n or p-type dopants are implanted into the substrate 106 to a concentration level between 1e12/cm³ - 5 e20/cm³. In an embodiment, the dopants are subsequently activated by a process of high temperature anneal to form a well 108 having an n-conductivity type or a p-conductivity type. The dopant implant process is targeted to various depths in the substrate 106 and in the fins 114, so that the fins 114 are adequately doped at the end of doping process to formed doped fins 114A (herein fins 114A). In the illustrative embodiment, the fins 114A can act as a mask during dopant implant, but a high temperature anneal process can be utilized to distribute dopants into regions directly under the fins 114A. After the doping process the mask 502 may be removed before a high temperature anneal process.

In an embodiment, the high temperature anneal process causes further diffusion of the dopant species in the substrate 106 and expanding the well 108 by a distance ranging from 10 nm to 20 nm laterally and an approximately equal distance vertically into the substrate 106 beyond the initial spatial extent of the well 108. Dopants that may have diffused under the mask and under fins 114C protected by the mask, may be removed in a subsequent process operation where portions of the substrate 106 are removed. In an embodiment, the high temperature anneal is carried out using a rapid thermal process (RTP) at a process temperature ranging from 500-1500 degrees Celsius and for a time duration ranging from 50s - 100s. In an embodiment, the RTP is performed in an ambient including one or more combination of gases such as but not limited to H₂, N₂, O_{2.} In an embodiment, the annealing process is carried out after forming a second well, as will be discussed below. In other embodiments, the anneal process is carried out after performing a second well implant and creating a second well in region 507 adjacent to region 505.

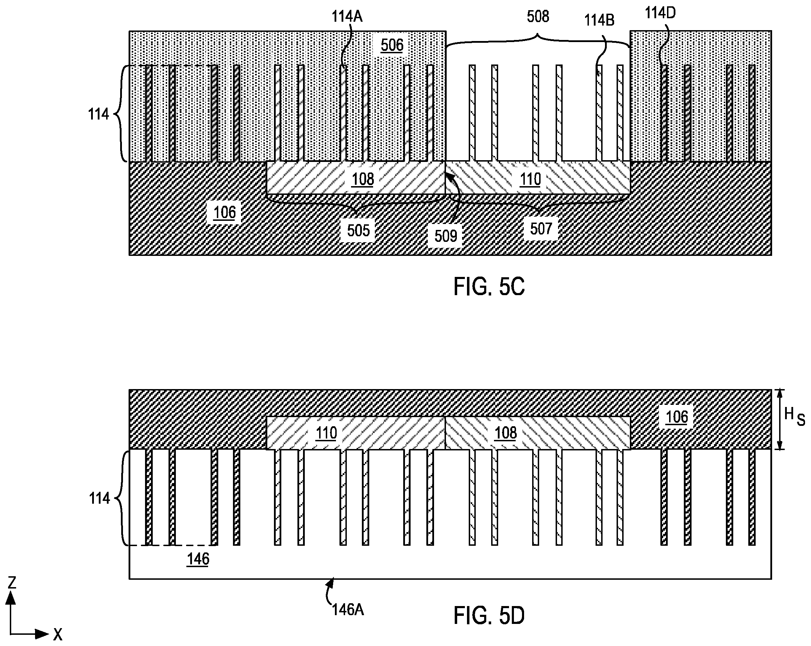

Figure 5C is a cross-sectional illustration of the structure in Figure 5B following the formation of a well 110 in the region 507, directly adjacent to well 108 and doping of a plurality of fins 114 directly above the well 110, in accordance with an embodiment of the present disclosure. The process operation described herein is a second of the mask and dual implant process.

In an embodiment, the process to form well 110 is substantially the same as process to form well 108. A mask 506 is formed on the fins 114, on the substrate 106 and on the well 108. The mask 506 includes an opening 508 that exposes fins 114 in a region 507 of the substate 106, directly adjacent to well 108. The dopant species chosen for well implant through the opening 508 have a conductivity type that is opposite to the dopant species implanted to form well 108 and fins 114A. The dopant concentration may be substantially identical to the processes utilized to dope and form well 108. The dopant implant process is targeted to various depths in the substrate 106 and in the fins 114 exposed by the mask 506. In an embodiment, the fins 114 are sufficiently doped at the end of doping process to formed doped fins 114B (herein fins 114B). The n or p-type dopants may be implanted into the region 507 of substrate 106 to a concentration level between 1e19/cm3 - 5 e20/cm3. In the illustrative embodiment, the fins 114B can act as a mask during dopant implant, but a high temperature anneal process can be utilized to distribute dopants into regions directly under the fins 114B. After the doping process the mask 506 may be removed before a high temperature anneal process.

In an embodiment, a thermal anneal process is performed after both n-type and p-type species have been implanted to limit lateral diffusion of dopants utilized to form well 108 into region 110. In one or more embodiments the dopant profile may be the same or substantially the same as a dopant profile obtained after forming well 108. Some dopants utilized to form well 110 may laterally diffuse under the mask 506 and under fins 114D after the anneal.

The dual implant process described above results in formation of wells 108 and fins 114A in region 505 and well 110 and fins 114B in region 507 directly adjacent to region 505 and forming a P-N junction at interface 509 at a boundary between wells 108 and 110.

Figure 5D is a cross-sectional illustration of the structures in Figure 5C following a process to deposit a dielectric 146 on the fins 114, followed by removal of a portion of the substrate 106. In an embodiment, the dielectric layer 146 is blanket deposited on the fins 114 and on portions of the substrate 106, and on the wells 108 and 110 by a plasma enhanced chemical vapor deposition (PECVD) or a chemical vapor deposition (CVD) process. In an embodiment, the dielectric layer 146 includes silicon and one or more of nitrogen, oxygen and carbon, for example, silicon nitride, silicon dioxide, carbon doped silicon nitride, silicon oxynitride or silicon carbide.

After the deposition process the dielectric layer 146 may be planarized to form a substantially flat surface 146A. A chemical mechanical polish (CMP) process may be utilized to perform a planarization process. In embodiments, portion of the dielectric 146 is left above the fins 114 for protection of uppermost fin surfaces during a subsequent planarization process.

In the illustrative embodiment, combination of wet chemical, plasma etch, and a CMP process may be utilized to remove portions of the substrate 106. In an embodiment, the combined vertical thickness, H_{S}, of the substrate 106 (excluding fins 114) and well 108 or 110 is less than 500nm. In exemplary embodiments, the thickness can be less than 200 nm. In embodiments, H_{S} is designed to substantially match a height of interconnects to be formed laterally adjacent to the substrate 106 and well 108 or 110.

Figure 5E is a cross-sectional illustration of the structures in Figure 5D following the process to etch and remove portions of the substrate 106 away from the wells 108 and 110 and expose a surface of each of the fins 114C and 114D. In an embodiment, a mask 510 is formed above the substrate. The mask 510 may include a hardmask fashioned from a dielectric material such as a silicon nitride, silicon carbide, silicon oxynitride etc. In some embodiments, a metal hard mask may be utilized. A metal hardmask may help to provide vertical etch profiles of the substrate and wells. A metal hardmask may be desirable in some embodiments where the substate is silicon or silicon germanium because a plasma etch process implemented may utilize oxygen gas in addition to a corrosive etchant to etch the silicon or silicon germanium. Implementation of oxygen containing etchants can provided enhanced selectivity during patterning of silicon or silicon germanium substrates. Metal hard masks may provide robust etch selectivity against silicon enabling etching of thick substrates, such as 200 nm or above. Because of proximity to a nearby fin 114C or 114D, it is desirable to have profile of the well 108 and 110 to be as vertical as possible. In an exemplary embodiment, a plasma etch process is utilized to obtain an anisotropic etch profile. In some embodiments a combination of wet etch and plasma etch may be utilized.

In the illustrative embodiment, expanded portions of wells 108 and 110 (indicated by curved lines 511) that are formed by diffusion of dopants are not protected by the mask 510 and removed by the etch process. The plasma etch process may be utilized to end point and stop once the dielectric 146 is exposed. An end-point detection program can be advantageously utilized to detect dielectric 146 after the substrate 106 is etched. Given that a majority of the wafer 512 includes exposed dielectric 146, an-endpoint program can be reliably utilized to etch the substrate 106 and prevent over etching into the fins 114C and 114D. In some embodiments, uppermost portions (in the rotated Figure) of the fins 114C and 114D may be partially etched during the etch process but not appreciable to detrimentally affect devices that will be formed utilizing fins 114C and 114D. It is to be appreciated that the doped fins 114A and 114B are not exposed during the etch process as they are covered by the mask 510.

In the illustrative embodiment, wells 108 and 110 have sidewalls 101A and 101B that are substantially vertical. In other embodiments, the sidewalls 101A and 101B may be tapered outward towards interface with dielectric 146. In other embodiments, the mask 510 is wider than a combined lateral width, L_{W} of the wells 108 and 110. In some such embodiments, portions of the substrate 106 remains adjacent to the wells 108 and 110, as indicated by substrate 106 (within dashed lines). The mask 510 may be removed after etching of substrate 106.

Figure 5F is a cross-sectional illustration of the structures in Figure 5E following the process to deposit a dielectric layer 514 on the upper surface (in the rotated illustration) of each of the plurality of fins 114C and 114D and form a first plurality of interconnects 103 and 104 in the dielectric 122 laterally spaced from the substrate 106, in accordance with an embodiment of the present disclosure. In an embodiment, the dielectric 514 includes a material that is blanket deposited on the substrate 106, on the dielectric 146, on fins 114C and 114D and on the mask 510. The dielectric 514 may be deposited by a plasma enhanced chemical vapor deposition (PECVD) or a chemical vapor deposition (CVD) process. In an embodiment, the dielectric layer 514 includes silicon and one or more of nitrogen, oxygen and carbon, for example, silicon nitride, silicon dioxide, carbon doped silicon nitride, silicon oxynitride or silicon carbide. In an embodiment, a planarization process is utilized to remove portions of the dielectric above the mask 510 (in dashed box), the mask 510 and portions of the dielectric 514 adjacent to the mask 510. In other embodiments, the dielectric above the mask 510 is planarized, but left above the mask 510 until openings for interconnects are formed and material of the interconnects 103 and 104 are deposited.

In an embodiment, openings 513 and 515 are formed in the dielectric 122. One or more metallization layers may be deposited into the openings 513 and 515 and on the surface of the dielectric 514. In some embodiments where a surface 106A of substrate 106 is exposed post dielectric 514 deposition and planarization, the metallization layers is also deposited on surfaces of the substrate 106. In other embodiments, metallization layers are deposited on surfaces of the dielectric 514 when substrate 106 is not exposed.

In an embodiment, deposition of the metallization layers includes forming a liner layer 516 in the openings 513 and 515 and on the dielectric 514, as is shown. A fill metal 517 may be deposited in the opening 515 on the liner layer 516 as well as outside the openings 513 and 515. In an exemplary embodiment, a material including ruthenium, tantalum nitride or tantalum may be used as a liner layer 516 in the openings 513 and 515 followed by deposition of a fill metal 517 such as copper, tungsten, ruthenium or molybdenum on the liner layer 516. The liner layer 516 also serves as a barrier layer against copper diffusion into a vicinity of the fins 114C and 114D, and into wells 108 and 110.

In an embodiment, a planarization process is utilized to remove the excess liner layer 516 and fill metal 517 to form interconnects 103 and 104 as shown. It is to be appreciated that a height, H₁ of level 102, relative to dielectric surface 146A is determined by the planarization process.

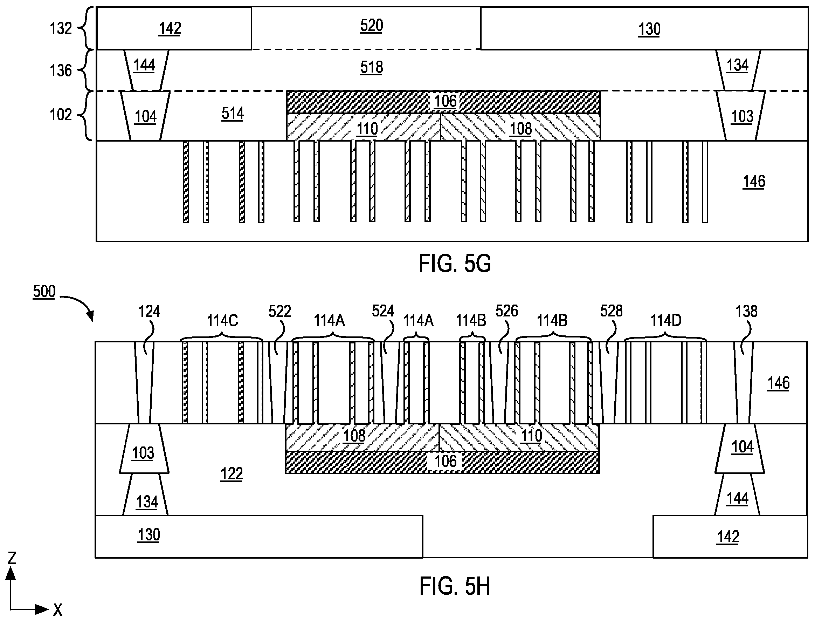

Figure 5G is a cross-sectional illustration of the structures in Figure 5F following the process to deposit a dielectric layer 518 on the interconnects 103 and 104, on the substrate 106 and on the dielectric 514. The dielectric 518 may be deposited by a plasma enhanced chemical vapor deposition (PECVD) or a chemical vapor deposition (CVD) process. Dielectric 518 may be deposited to a thickness that is desired to tune a height of interconnects to be formed within level 136. Dielectric 518 includes a material that is the same or substantially the same as the material of the dielectric 514. The interconnects 134 and 144 may be formed by a same or substantially the same method as a method utilized to fabricate interconnects 103 and 104.

After formation of interconnects 134 and 144, a dielectric 520 is subsequently blanket deposited on the interconnect 134 and 144 and on the dielectric 520. Blanket deposition may be performed using a plasma enhanced chemical vapor deposition (PECVD) or a chemical vapor deposition (CVD) process. Dielectric 520 includes a material that is the same or substantially the same as the material of the dielectric 518 or 514. Dielectric 520 may be deposited to a thickness that is desired to tune a height of routing plates to be formed. The routing plates 142 and 130 may be formed using a same or substantially the same method as a method utilized to fabricate interconnects 103 and 104. In the illustrative embodiment, the liner layers and fill layers are removed for clarity.

Figure 5H is a cross-sectional illustration of the structures in Figure 5G following the process to form a plurality of interconnect vias in the dielectric 146 adjacent to fins 114A, 114B, 114C, and 114D. When the dielectrics 514, 518 and 520 include a same material, dielectrics 514, 518 and 520 are consolidated into a single dielectric 122 as shown in the illustration.

After formation of plates 142 and 130, processing is resumed on the fin 114 side of wafer 500. In an embodiment, openings are formed in the dielectric 146 by masking the dielectric 146 and fins 114A, 114B, 114C, and 114D. In an embodiment, interconnects may be formed after fabrication of transistors above the fins 114C, and 114D. In other embodiments interconnects 124, 138, 522, 524, 526 and 528 may be formed prior to forming transistors above fins 114C and 114D. In an embodiment, the process to fabricate interconnects 124, 138, 522, 524, 526 and 528 includes a method that is the same or substantially the same as the method utilized to fabricate interconnect 103 or 104. However, the materials utilized may be different depending on whether the interconnects are formed before or after the transistors are formed above fins 114C and 114D. Copper or other conductive materials that are prone to diffusion may not be compatible with front end of the line transistor fabrication methods.

In an embodiment, fabricating the interconnects 124, 138, 522, 524, 526 and 528 includes depositing a liner layer including tantalum, titanium nitride, tantalum nitride, or ruthenium and a fill metal such as but not limited to tungsten or ruthenium on the liner layer in openings formed in the dielectric 146.

In some embodiments, fabrication of interconnect vias 522, 524, 526 and 528 is optional. In other embodiments, vias 524 and 526 may be fabricated and routed to a routing lines such as routing line 126 and 140, respectively (described in association with Figure 1A), however fabrication of interconnects 522 and 528 may be optional.

In an embodiment, devices such as transistors above fins 114C and 114D, and interconnect routing to transistors can be fabricated next and routing lines 126 and 140 (not shown in Figure) can be fabricated once the transistors are fabricated.

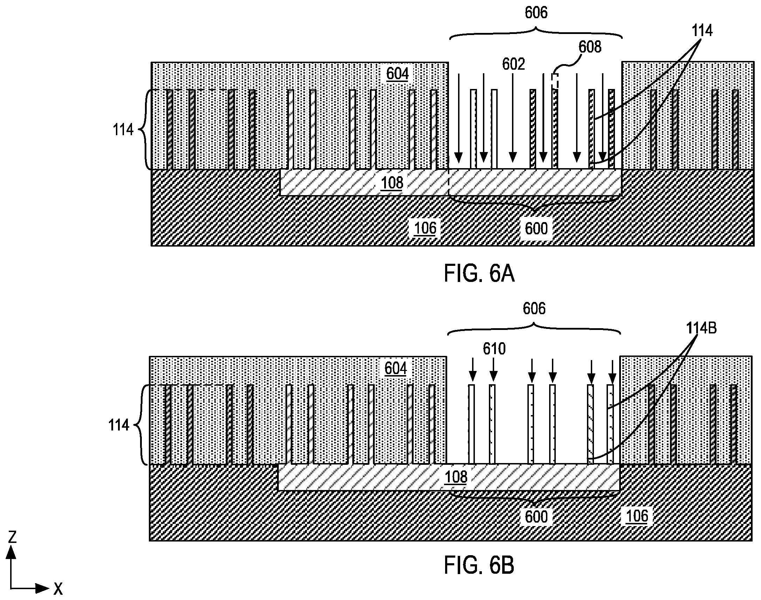

While a method to fabricate the semiconductor structure 100 has been described, methods to fabricate other embodiments of the semiconductor structure 100 described herein may utilize one or more processing operations described above. When a single well such as well 108 or 110 only is desired, then the process operations described in association with Figures 5B and 5C may be modified to include different mask sizes and target an appropriate doping depth within the fin structures 114B. The modification is illustrated in Figure 6A and 6B.

Figure 6A is a cross-sectional illustration of the structure in Figure 5B f following a first of a dual stage implant process, where a first stage of the implant includes implanting a dopant of a same conductivity type to the dopant utilized to form well 108 into a region 600 of substrate 106 directly adjacent to the well 108. In the illustrative embodiment, the implant process (indicated by arrows 602) targets dopants into a region 600 of the substrate 106 adjacent to well 108 through opening 606 in mask 604. Region 600 is an expansion of the well 108 and is doped in two stages to prevent doping of the fins 114 exposed in the opening 606.

In some such embodiment, the dopants and dopant concentration are the same as the dopants and dopant concentration utilized to form well 108, where the conductivity type of the dopant may be N or P type. In some embodiments, some negligible amount of dopants will be absorbed by the fins 114 during this process because the doping process predominantly targets implants into the region 600 of substrate 106.

In other embodiments, a hardmask material, indicated by dashed box 608 can be left on the fins 114B post patterning, where the hardmask material can be utilized to block the dopants from reaching the fins.

Figure 6B is a cross-sectional illustration of the structure in Figure 6A following a second of a dual stage implant process, where a second stage of the dual stage implant includes implanting a dopant of a different conductivity type to the dopant utilized to expand well 108 into the region 600 of substrate 106. In exemplary embodiments, the implant process (indicated by arrows 610) target dopants to a shallower depth than during a process to implant to form well 108.

In exemplary embodiments, implant dopant density or concentration level targeted in the fins 114 in the opening 606 is the same or substantially the same as a dopant density or concentration level targeted to form well 108. N or P-type dopants (n-type if well 108 is p-type or vice versa) may be implanted into the fins to a concentration level between 1e12/cm3 - 5 e20/cm3. In some embodiments, the dopant density or concentration level targeted to produce doped fins 114B is reduced compared a dopant density or concentration level targeted to form well 108. In other embodiments, the well 108 could be masked with a flowable material including carbon and oxygen to protect the well 108 during doping to fabricate doped fins 114B. The flowable material could partially fill the opening 606.

In embodiments, where the semiconductor structure includes a SOI substrate such as is depicted in Figure 3, the method described in association with Figures 5A-5H and Figure 6A may be utilized.

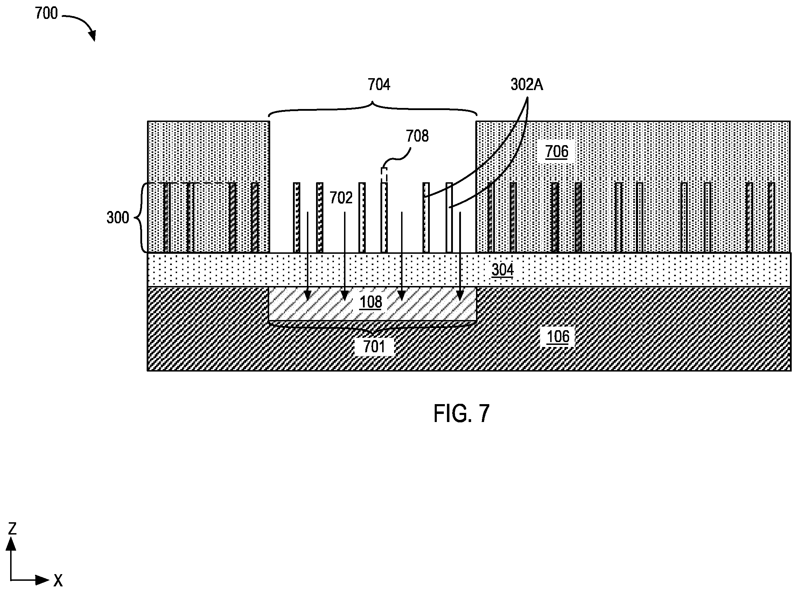

Figure 7 is a cross-sectional illustration of process to form a well 108 in the substrate 106 of a workpiece 700 that includes a plurality of fins 300 fabricated above the substrate 106. In the illustrative embodiment, the targeted region 701 for well formation is below a level of insulator layer 304. In an embodiment, a high energy implantation process (indicated by arrows 702) is utilized to drive implants into a region 701 below the insulator layer 304 directly below opening 704 in mask 706. The high energy implantation process is designed to implant dopants into the substrate 106 and limit dopants from being implanted into the fins 302A within the opening 704. In embodiments, hardmask 708 can be left on fins 302A to prevent dopants from being implanted in the fins 302A. In the illustrative embodiment, the fins 302A can act as a mask during dopant implant, but a high temperature anneal process can be utilized to distribute dopants into regions directly under the fins 302A.

Because the fins 302A are not designed to be terminals, implantation is not required for a diode fabricated downstream. Hence, the method described herein can be replicated to create a well laterally adjacent to well 108 and form a P-N junction diode. Once both N and P wells are formed. The process operations outlined above in association with Figures 5D - 5H or some variations thereof can be implemented to fabricate transistors above the fins 300. It is to be appreciated that fins 300 may include a stack of layers that can be utilized in the formation of nanowire transistors or fin-FET devices. In fin-FET devices, portions of the fins 302 can be replaced in source and in drain regions of fins 300 by etching and regrowing doped epitaxial structures to enable P and/or N-MOS devices.

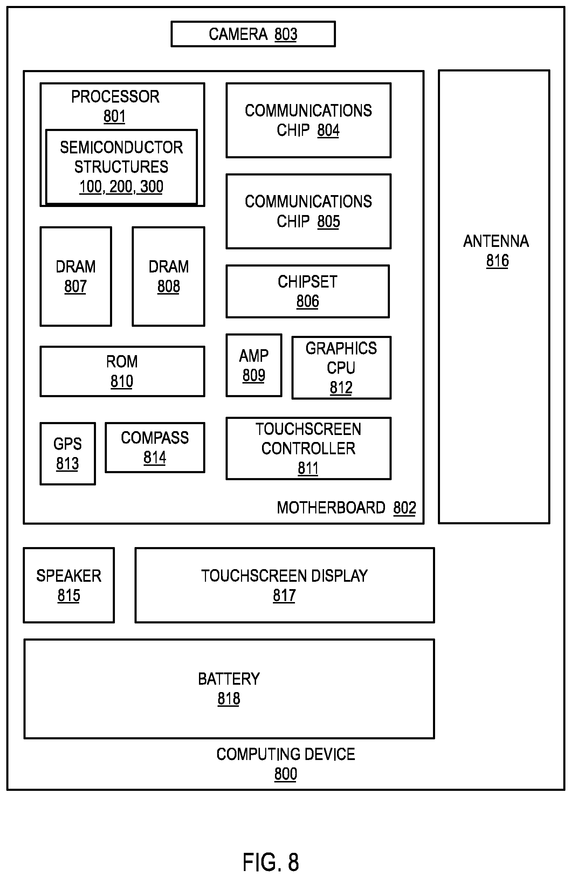

Figure 8 illustrates a computing device 800 in accordance with embodiments of the present disclosure. As shown, computing device 800 houses a motherboard 802. Motherboard 802 may include a number of components, including but not limited to a processor 801 and at least one communications chip 804 or 805. Processor 801 is physically and electrically coupled to the motherboard 802. In some implementations, communications chip 805 is also physically and electrically coupled to motherboard 802. In further implementations, communications chip 805 is part of processor 801.

Depending on its applications, computing device 800 may include other components that may or may not be physically and electrically coupled to motherboard 802. These other components include, but are not limited to, volatile memory (e.g., DRAM), non-volatile memory (e.g., ROM), flash memory, a graphics processor, a digital signal processor, a crypto processor, a chipset 806, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

Communications chip 805 enables wireless communications for the transfer of data to and from computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communications chip 805 may implement any of a number of wireless standards or protocols, including but not limited to Wi-Fi (IEEE 801.11 family), WiMAX (IEEE 801.11 family), long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 8G, and beyond. Computing device 800 may include a plurality of communications chips 804 and 805. For instance, a first communications chip 805 may be dedicated to shorter range wireless communications such as Wi-Fi and Bluetooth and a second communications chip 804 may be dedicated to longer range wireless communications such as GPS, EDGE, GPRS, CDMA, WiMAX, LTE, Ev-DO, and others.

Processor 801 of the computing device 800 includes an integrated circuit die packaged within processor 801. In some embodiments, the integrated circuit die of processor 801 includes non-volatile memory devices, one or more semiconductor structures such as semiconductor structures 100, 200 or 300 that include an ESD protection diode and transistors adjacent to the ESD protection diode, as described in association with Figures 1A-1C, 2 or 3. Referring again to Figure 8, the term "processor" may refer to any device or portion of a device that processes electronic data from registers and/or memory to transform that electronic data into other electronic data that may be stored in registers and/or memory.

Communications chip 805 also includes an integrated circuit die packaged within communication chip 805. In another embodiment, the integrated circuit die of communications chips 804, 805 includes one or more interconnect structures, non-volatile memory devices, capacitors. Depending on its applications, computing device 800 may include other components that may or may not be physically and electrically coupled to motherboard 802. These other components may include, but are not limited to, volatile memory (e.g., DRAM) 807, 808, non-volatile memory (e.g., ROM) 810, a graphics CPU 812, flash memory, global positioning system (GPS) device 813, compass 814, a chipset 806, an antenna 816, a power amplifier 809, a touchscreen controller 811, a touchscreen display 817, a speaker 815, a camera 803, and a battery 818, as illustrated, and other components such as a digital signal processor, a crypto processor, an audio codec, a video codec, an accelerometer, a gyroscope, and a mass storage device (such as hard disk drive, solid state drive (SSD), compact disk (CD), digital versatile disk (DVD), and so forth), or the like. In further embodiments, any component housed within computing device 800 and discussed above may contain a stand-alone integrated circuit memory die that includes one or more arrays of nonvolatile memory devices.

In various implementations, the computing device 800 may be a laptop, a netbook, a notebook, an Ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

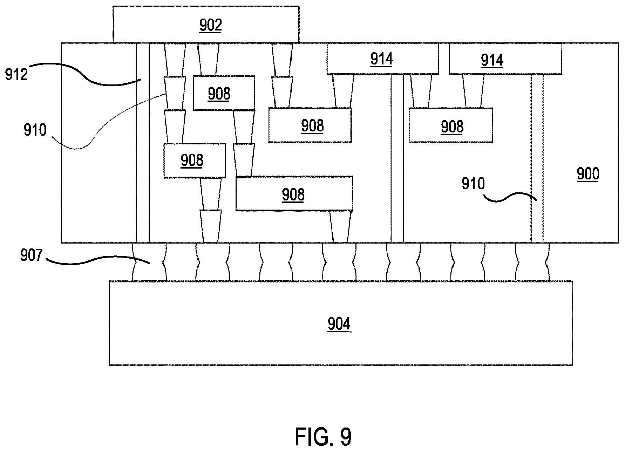

Figure 9 illustrates an integrated circuit (IC) structure 900 that includes one or more embodiments of the disclosure. The integrated circuit (IC) structure 900 is an intervening substrate used to bridge a first substrate 902 to a second substrate 904. The first substrate 902 may be, for instance, an integrated circuit die. The second substrate 904 may be, for instance, a memory module, a computer mother, or another integrated circuit die. Generally, the purpose of an integrated circuit (IC) structure 900 is to spread a connection to a wider pitch or to reroute a connection to a different connection. For example, an integrated circuit (IC) structure 900 may couple an integrated circuit die to a ball grid array (BGA) 907 that can subsequently be coupled to the second substrate 904. In some embodiments, the first substrate 902 and the second substrate 904 are attached to opposing sides of the integrated circuit (IC) structure 900. In other embodiments, the first substrate 902 and the second substrate 904 are attached to the same side of the integrated circuit (IC) structure 900. And in further embodiments, three or more substrates are interconnected by way of the integrated circuit (IC) structure 900.

The integrated circuit (IC) structure 900 may be formed of an epoxy resin, a fiberglass-reinforced epoxy resin, a ceramic material, or a polymer material such as polyimide. In further implementations, the integrated circuit (IC) structure may be formed of alternate rigid or flexible materials that may include the same materials described above for use in a semiconductor substrate, such as silicon, germanium, and other group Ill-V and group IV materials.

The integrated circuit (IC) structure may include metal interconnects 908 and vias 910, including but not limited to through-silicon vias (TSVs) 912. The integrated circuit (IC) structure 900 may further include embedded devices 914, including both passive and active devices. Such embedded devices 914 include capacitors, resistors, inductors, fuses, diodes, transformers, device structure including transistors. The integrated circuit (IC) structure 900 may further include embedded devices such as one or more resistive random-access devices, sensors, and electrostatic discharge (ESD) devices such as ESD protection diode 101 and transistors adjacent to the ESD protection diode 101 that are part of semiconductor structures 100, 200 or 300, as described in association with Figures 1A-1C, 2 or 3, respectively. Referring again to Figure 9, more complex devices such as radiofrequency (RF) devices, power amplifiers, power management devices, antennas, arrays, sensors, and MEMS devices may also be formed on the integrated circuit (IC) structure 900.

Semiconductor device structures including ESD protection diodes and transistors are described herein. In the above description, for purposes of explanation, numerous specific details are set forth in order to provide a thorough understanding of certain embodiments. It will be apparent, however, to one skilled in the art that certain embodiments can be practiced without these specific details. In other instances, structures and devices are shown in block diagram form in order to avoid obscuring the description.

Besides what is described herein, various modifications may be made to the disclosed embodiments and implementations thereof without departing from their scope. Therefore, the illustrations and examples herein should be construed in an illustrative, and not a restrictive sense. The scope of the invention should be measured solely by reference to the claims that follow.

## Claims

1. A semiconductor device structure comprising:
a first level (102) comprising:
a first interconnect (103) and a second interconnect (104);
a substrate (106) between the first and second interconnects; and
one or more wells (108, 110) on the substrate; and
a second level (112) comprising:
multiple fins (114) comprising a semiconductor material, the multiple fins further comprising:
a first fin (114A) and a second fin (114B) each on the one or more wells (108, 110), wherein the first fin
and the one or more wells comprise respective dopants each of a first conductivity type and wherein the second fin comprises a dopant of a second conductivity type different from the first conductivity type;
**characterized in that**:
the first fin, second fin and the one or more wells forming a diode structure (101); and
the second level further comprising:
a third fin (114C) over a first region (116) between the substrate and the first interconnect; and
a fourth fin (114D) over a second region (118) between the substrate and the second interconnect;
wherein the first and the second regions comprise a dielectric material;
a third interconnect (124) on the first interconnect and electrically coupled to the first fin; and
a fourth interconnect (138) on the second interconnect and electrically coupled to the second fin; and
wherein the semiconductor device structure further comprises transistors (150) on the third and on the fourth fins but not on the first or on the second fins.

2. The semiconductor device structure of claim 1, wherein the one or more wells comprises a first well and a second well, the second well laterally adjacent to the first well, wherein the first well has the first conductivity type and the second well has the second conductivity type, and wherein the first fin is on the first well and the second fin is on the second well.

3. The semiconductor device structure of claim 2, wherein the first conductivity type is an n-type, and second conductivity is a p-type.

4. The semiconductor device structure of any one of claims 1-3, wherein the first fin is one of a first plurality of fins, the second fin is one of a second plurality of fins, the third fin is one of a third plurality of fins and the fourth fin is one of a fourth plurality of fins and wherein individual ones of the first, the second, the third and the fourth plurality of fins are discrete and have a same width and a same pitch.

5. The semiconductor device structure of any one of claims 1-4, wherein the substrate comprises silicon, and the semiconductor material comprises silicon.

6. The semiconductor device structure of any one of claims 1-5, wherein the substrate and the one or more wells have a combined vertical thickness of 200 nm or less.

7. The semiconductor device structure of any one of claims 1-6, wherein the first and the second fins have a dopant gradient that increases in concentration toward the one or more wells.

8. The semiconductor device structure of any one of claims 1-7, wherein the one or more wells comprises a third well comprising the first conductivity type and wherein the first fin and a second fin are each on the third well.

9. The semiconductor device structure of any one of claims 1-8, wherein the first conductivity type is an n-type, and second conductivity is a p-type.

10. The semiconductor device structure of any one of claims 1-8, wherein the first conductivity type is a p-type, and second conductivity is an n-type.

11. The semiconductor device structure of any one of claims 1-8, further comprising:
a fifth interconnect laterally extending from above the third interconnect to the first fin, wherein the fifth interconnect is electrically coupled between the third interconnect and the first fin; and
a sixth interconnect laterally extending from above the fourth interconnect to the second fin, wherein the sixth interconnect is electrically coupled between the fourth interconnect and the second fin.

12. A system comprising:
a battery;
an antenna; and
a processor coupled to the antenna, wherein the processor includes the semiconductor device structure of any of claims 1 to 11.

13. The system of claim 12, wherein the one or more wells comprises a first well and a second well, the second well laterally adjacent to the first well, wherein the first well has the first conductivity type and the second well has the second conductivity type, and wherein the first fin is on the first well and the second fin is on the second well.

## Patentansprüche

1. Halbleitervorrichtungsstruktur, die Folgendes umfasst:
eine erste Ebene (102), die Folgendes umfasst:
eine erste Verbindung (103) und eine zweite Verbindung (104);
ein Substrat (106) zwischen der ersten und der zweiten Verbindung; und
einen oder mehrere Potentialtöpfe (108, 110) auf dem Substrat; und
eine zweite Ebene (112), die Folgendes umfasst:
mehrere Rippen (114), die ein Halbleitermaterial umfassen, wobei die mehreren Rippen ferner Folgendes umfassen:
eine erste Rippe (114A) und eine zweite Rippe (114B) jeweils auf dem einen oder den mehreren Potentialtöpfen (108, 110), wobei die erste Rippe
und der eine oder die mehreren Potentialtöpfe jeweilige Dotierstoffe jeweils eines ersten Leitfähigkeitstyps umfassen und wobei die zweite Rippe einen Dotierstoff eines zweiten Leitfähigkeitstyps, der vom ersten Leitfähigkeitstyp verschieden ist, umfasst; **dadurch gekennzeichnet, dass**:
die erste Rippe, die zweite Rippe und der eine oder die mehreren Potentialtöpfe eine Diodenstruktur (101) bilden; und
die zweite Ebene ferner Folgendes umfasst:
eine dritte Rippe (114C) über einem ersten Bereich (116) zwischen dem Substrat und der ersten Verbindung; und
eine vierte Rippe (114D) über einem zweiten Bereich (118) zwischen dem Substrat und der zweiten Verbindung;
wobei der erste und der zweite Bereich ein dielektrisches Material umfassen;
eine dritte Verbindung (124) auf der ersten Verbindung und mit der ersten Rippe elektrisch gekoppelt; und
eine vierte Verbindung (138) auf der zweiten Verbindung und mit der zweiten Rippe elektrisch gekoppelt;
wobei die Halbleitervorrichtungsstruktur ferner Transistoren (150) auf der dritten und auf der vierten Rippe, jedoch nicht auf der ersten oder auf der zweiten Rippe umfasst.

2. Halbleitervorrichtungsstruktur nach Anspruch 1, wobei der eine oder die mehreren Potentialtöpfe einen ersten Potentialtopf und einen zweiten Potentialtopf umfassen, der zweite Potentialtopf seitlich zum ersten Potentialtopf benachbart ist, wobei der erste Potentialtopf den ersten Leitfähigkeitstyp aufweist und der zweite Potentialtopf den zweiten Leitfähigkeitstyp aufweist und wobei die erste Rippe sich auf dem ersten Potentialtopf befindet und die zweite Rippe sich auf dem zweiten Potentialtopf befindet.

3. Halbleitervorrichtungsstruktur nach Anspruch 2, wobei der erste Leitfähigkeitstyp ein n-Typ ist und der zweite Leitfähigkeitstyp ein p-Typ ist.

4. Halbleitervorrichtungsstruktur nach einem der Ansprüche 1-3, wobei die erste Rippe eine einer ersten Mehrzahl von Rippen ist, die zweite Rippe eine einer zweiten Mehrzahl von Rippen ist, die dritte Rippe eine einer dritten Mehrzahl von Rippen ist und die vierte Rippe eine einer vierten Mehrzahl von Rippen ist und wobei die einzelnen der ersten, der zweiten, der dritten und der vierten Mehrzahl von Rippen getrennt sind und dieselbe Breite und dieselbe Schrittweite aufweisen.

5. Halbleitervorrichtungsstruktur nach einem der Ansprüche 1-4, wobei das Substrat Silizium enthält und das Halbleitermaterial Silizium enthält.

6. Halbleitervorrichtungsstruktur nach einem der Ansprüche 1-5, wobei das Substrat und der eine oder die mehreren Potentialtöpfe eine kombinierte vertikale Dicke von 200 nm oder weniger aufweisen.

7. Halbleitervorrichtungsstruktur nach einem der Ansprüche 1-6, wobei die erste und die zweite Rippe einen Dotierstoffgradienten aufweisen, der bezüglich der Konzentration in Richtung des einen oder der mehreren Potentialtöpfe zunimmt.

8. Halbleitervorrichtungsstruktur nach einem der Ansprüche 1-7, wobei der eine oder die mehreren Potentialtöpfe einen dritten Potentialtopf umfassen, der den ersten Leitfähigkeitstyp umfasst, und wobei die erste Rippe und die zweite Rippe sich jeweils auf dem dritten Potentialtopf befinden.

9. Halbleitervorrichtungsstruktur nach einem der Ansprüche 1-8, wobei der erste Leitfähigkeitstyp ein n-Typ ist und der zweite Leitfähigkeitstyp ein p-Typ ist.

10. Halbleitervorrichtungsstruktur nach einem der Ansprüche 1-8, wobei der erste Leitfähigkeitstyp ein p-Typ ist und der zweite Leitfähigkeitstyp ein n-Typ ist.

11. Halbleitervorrichtungsstruktur nach einem der Ansprüche 1-8, die ferner Folgendes umfasst:
eine fünfte Verbindung, die sich seitlich von oberhalb der dritten Verbindung zur ersten Rippe erstreckt,
wobei die fünfte Verbindung zwischen der dritten Verbindung und der ersten Rippe elektrisch gekoppelt ist; und
eine sechste Verbindung, die sich seitlich von oberhalb der vierten Verbindung zur zweiten Rippe erstreckt,
wobei die sechste Verbindung zwischen der vierten Verbindung und der zweiten Rippe elektrisch gekoppelt ist.

12. System, das Folgendes umfasst:
eine Batterie;
eine Antenne; und
einen Prozessor, der mit der Antenne gekoppelt ist, wobei der Prozessor die Halbleitervorrichtungsstruktur nach einem der Ansprüche 1 bis 11 enthält.

13. System nach Anspruch 12, wobei der eine oder die mehreren Potentialtöpfe einen ersten Potentialtopf und einen zweiten Potentialtopf umfassen, der zweite Potentialtopf seitlich zum ersten Potentialtopf benachbart ist, wobei der erste Potentialtopf den ersten Leitfähigkeitstyp aufweist und der zweite Potentialtopf den zweiten Leitfähigkeitstyp aufweist und wobei die erste Rippe sich auf dem ersten Potentialtopf befindet und die zweite Rippe sich auf dem zweiten Potentialtopf befindet.

## Revendications

1. Structure de dispositif à semi-conducteur, comprenant :
un premier niveau (102) comprenant :
une première interconnexion (103) et une deuxième interconnexion (104) ;
un substrat (106) entre les première et deuxième interconnexions ; et
un ou plusieurs caissons (108, 110) sur le substrat ; et
un deuxième niveau (112) comprenant :
de multiples ailettes (114) comprenant un matériau semi-conducteur, les multiples ailettes comprenant en outre :
une première ailette (114A) et une deuxième ailette (114B) situées chacune sur les un ou plusieurs caissons (108, 110), la première ailette
et les un ou plusieurs caissons comprenant des dopants respectifs chacun d'un premier type de conductivité et la deuxième ailette comprenant un dopant d'un deuxième type de conductivité différent du premier type de conductivité ; **caractérisée en ce que** :
la première ailette, la deuxième ailette et les un ou plusieurs caissons forment une structure de diode (101) ; et
le deuxième niveau comprenant en outre :
une troisième ailette (114C) au-dessus d'une première région (116) entre le substrat et la première interconnexion ; et
une quatrième ailette (114D) au-dessus d'une deuxième région (118) entre le substrat et la deuxième interconnexion ;
les première et deuxième régions comprenant un matériau diélectrique ;
une troisième interconnexion (124) sur la première interconnexion et couplée électriquement à la première ailette ; et
une quatrième interconnexion (138) sur la deuxième interconnexion et couplée électriquement à la deuxième ailette ; et
la structure de dispositif à semi-conducteur comprenant en outre des transistors (150) sur la troisième et sur la quatrième ailette mais pas sur la première et sur la deuxième ailette.

2. Structure de dispositif à semi-conducteur selon la revendication 1, dans laquelle les un ou plusieurs caissons comprennent un premier caisson et un deuxième caisson, le deuxième caisson étant latéralement adjacent au premier caisson, dans laquelle le premier caisson présente le premier type de conductivité et le deuxième caisson présente le deuxième type de conductivité, et dans laquelle la première ailette est située sur le premier caisson et la deuxième ailette est située sur le deuxième caisson.

3. Structure de dispositif à semi-conducteur selon la revendication 2, dans laquelle le premier type de conductivité est le type N, et le deuxième type de conductivité est le type P.

4. Structure de dispositif à semi-conducteur selon l'une quelconque des revendications 1 à 3, dans laquelle la première ailette est l'une d'une première pluralité d'ailettes, la deuxième ailette est l'une d'une deuxième pluralité d'ailettes, la troisième ailette est l'une d'une troisième pluralité d'ailettes et la quatrième ailette est l'une d'une quatrième pluralité d'ailettes, et dans laquelle des ailettes individuelles parmi la première, la deuxième, la troisième et la quatrième pluralité d'ailettes sont discrètes et présentent la même largeur et le même pas.

5. Structure de dispositif à semi-conducteur selon l'une quelconque des revendications 1 à 4, dans laquelle le substrat comprend du silicium, et le matériau semi-conducteur comprend du silicium.

6. Structure de dispositif à semi-conducteur selon l'une quelconque des revendications 1 à 5, dans laquelle le substrat et les un ou plusieurs caissons présentent une épaisseur verticale combinée inférieure ou égale à 200 nm.

7. Structure de dispositif à semi-conducteur selon l'une quelconque des revendications 1 à 6, dans laquelle les première et deuxième ailettes présentent un gradient de dopant dont la concentration augmente en direction des un ou plusieurs caissons.

8. Structure de dispositif à semi-conducteur selon l'une quelconque des revendications 1 à 7, dans laquelle les un ou plusieurs caissons comprennent un troisième caisson comprenant le premier type de conductivité, et dans laquelle la première ailette et une deuxième ailette se situent chacune sur le troisième caisson.

9. Structure de dispositif à semi-conducteur selon l'une quelconque des revendications 1 à 8, dans laquelle le premier type de conductivité est le type N, et le deuxième type de conductivité est le type P.

10. Structure de dispositif à semi-conducteur selon l'une quelconque des revendications 1 à 8, dans laquelle le premier type de conductivité est le type P, et le deuxième type de conductivité est le type N.

11. Structure de dispositif à semi-conducteur selon l'une quelconque des revendications 1 à 8, comprenant en outre :
une cinquième interconnexion s'étendant latéralement depuis le dessus de la troisième interconnexion jusqu'à la première ailette,
la cinquième interconnexion étant couplée électriquement entre la troisième interconnexion et la première ailette ; et
une sixième interconnexion s'étendant latéralement depuis le dessus de la quatrième interconnexion jusqu'à la deuxième ailette,
la sixième interconnexion étant couplée électriquement entre la quatrième interconnexion et la deuxième ailette.

12. Système comprenant :
une batterie ;
une antenne ; et
un processeur couplé à l'antenne, le processeur comportant la structure de dispositif à semi-conducteur selon l'une quelconque des revendications 1 à 11.

13. Système selon la revendication 12, dans lequel les un ou plusieurs caissons comprennent un premier caisson et un deuxième caisson, le deuxième caisson étant latéralement adjacent au premier caisson, dans lequel le premier caisson présente le premier type de conductivité et le deuxième caisson présente le deuxième type de conductivité, et dans lequel la première ailette est située sur le premier caisson et la deuxième ailette est située sur le deuxième caisson.
